# EUROPEAN PATENT APPLICATION

(11) **EP 1 857 877 A1**
(43) Date of publication of application: **21.11.2007**
(21) Application number: 06713473.4
(22) Date of filing: 10.02.2006
(51) Int. Cl.: G03F 7/11, G03F 7/00, G03F 7/105

(54) **PHOTOSENSITIVE PLANOGRAPHIC PRINTING PLATE MATERIAL**

(30) Priority: 09.03.2005 JP 2005065057
(71) Applicant: Konica Minolta Medical & Graphic, Inc., Tokyo 163-0512 (JP)
(72) Inventor: MATSUMURA, Toshiyuki, ikawa-machi, Hachioji-shi, Tokyo, 192850 (JP)
(74) Representative: Gille Hrabal Struck Neidlein Prop Roos
(86) International application number: PCT/JP2006/302330
(87) International publication number: WO 2006/095535

(57) **Abstract**

The present invention provides a light sensitive planographic printing plate material which is adapted to exposure employing a laser emitting light with an emission wavelength of from 350 to 450 nm, and which exhibits high sensitivity and excellent safelight property, and a light sensitive planographic printing plate material comprising a support and provided thereon, a light sensitive layer and a protective layer (E), the light sensitive layer containing a photopolymerization initiator (A), a polymerizable ethylenically unsaturated compound (B), a dye (C) having absorption maximum in the wavelength regions of from 350 to 450 nm and a polymeric binder (D), and the light sensitive planographic printing plate material being **characterized in that** the protective layer contains a dye precursor (F) capable of changing to a dye absorbing light with a wavelength of from 350 to 450 nm by heating.

## Description

### FIELD OF THE INVENTION

The present invention relates to a light sensitive planographic printing plate material used in a computer-to-plate (hereinafter referred to as CTP) system, and particularly to a light sensitive planographic printing plate material suitable for exposure employing laser light having a wavelength of from 350 to 450 nm.

### TECHNICAL BACKGROUND

In recent years, a CTP system has been developed and put into practical use, which directly writes digital image data on a light sensitive planographic printing plate material employing laser light in a process of manufacturing a printing plate for off-set printing.

In a printing field in which relatively high printing durability is required, a negative working light sensitive planographic printing plate material is known which comprises a polymerizable light sensitive layer containing a polymerizable compound (see for example, Japanese Patent O.P.I. Publication Nos. 1-105238 and 2-127404).

A light sensitive printing plate material capable of being imagewise exposed with laser having an emission wavelength from 390 to 430 nm is known, which improves safelight property in view of handling.

A compact blue-violet laser of high output power emitting rays with a wavelength of from 390 to 430 nm can be easily obtained. Light sensitive printing plate materials adapted to this laser, which can be processed under room light, have been developed (see for example, Patent Document 1, 2 and 3). These printing plate materials can be processed under a relatively bright safelight, however, they have still problems in that it is difficult to maintain high sensitivity while maintaining good safelight property and to obtain both high sensitivity and good safelight property.
[Patent Document 1] Japanese Patent O.P.I. Publication No. 2000-35673
[Patent Document 2] Japanese Patent O.P.I. Publication No. 2000-98605
[Patent Document 3] Japanese Patent O.P.I. Publication No. 2001-264978

### DISCLOSURE OF THE INVENTION

### PROBLEMS TO BE SOLVED BY THE INVENTION

An object of the invention is to provide a light sensitive planographic printing plate material which is suitable for exposure employing a laser emitting light with an emission wavelength of from 350 to 450 nm, and which exhibits high sensitivity and excellent safelight property.

### MEANS FOR SOLVING THE ABOVE PROBLEMS

The above object has been attained by one of the following constitutions:
1. A light sensitive planographic printing plate material comprising a support and provided thereon, a light sensitive layer and a protective layer (E), the light sensitive layer containing a photopolymerization initiator (A), a polymerizable ethylenically unsaturated compound (B), a dye (C) having absorption maximum in the wavelength regions of from 350 to 450 nm and a polymeric binder (D), and the light sensitive planographic printing plate material being characterized in that the protective layer contains a dye precursor (F) capable of changing to a dye absorbing light with a wavelength of from 350 to 450 nm by heating.
2. The light sensitive planographic printing plate material of item 1 above, wherein the protective layer further contains a color-developing agent (G).

### EFFECTS OF THE INVENTION

The present invention can provide a light sensitive planographic printing plate material which is adapted to exposure employing a laser emitting light with an emission wavelength of from 350 to 450 nm, and which exhibits high sensitivity and excellent safelight property.

### PREFERRED EMBODIMENT OF THE INVENTION

The preferred embodiment of the present invention will be explained in detail below, but the invention is not specifically limited thereto.

In the light sensitive planographic printing plate material of the invention which comprises a support and provided thereon, a light sensitive layer and a protective layer (E), the light sensitive layer containing a photopolymerization initiator (A), a polymerizable ethylenically unsaturated compound (B), a dye (C) having absorption maximum in the wavelength regions of from 350 to 450 nm and a polymeric binder (D), the light sensitive planographic printing plate material is characterized in that the protective layer contains a dye precursor (F) capable of changing to a dye absorbing light with a wavelength of from 350 to 450 nm by heating.

Incorporation of the dye absorbing light with a wavelength of from 350 to 450 nm by heating in the protective layer provides high sensitivity and excellent safelight property.

Components contained in the image formation layer in the invention will be explained below.

### Polymerization initiator (A)

The photopolymerization initiator in the invention is a compound which initiates polymerization of an ethylenically unsaturated compound on light exposure. As the polymerization initiator, for example, a titanocene compound, a monoalkyltriaryl borate compound, an iron arene complex, a polyhalogenated compound or a biimidazole compound is used.

As the titanocene compounds, there are those described in Japanese Patent O.P.I. Publication Nos. 63-41483 and 2-291. Preferred examples of titanocene compounds include bis(cyclopentadienyl)-Ti-di-chloride, bis(cyclopentadienyl)-Ti-bis-phenyl, bis(cyclopentadienyl)-Ti-bis-2,3,4,5,6-pentaflurophenyl, bis(cyclopentadienyl)-Ti-bis-2,3,5,6-tetrafluorophenyl, bis(cyclopentadienyl)-Ti-bis-2,4,6-trifluorophenyl, bis(cyclopentadienyl)-Ti-bis-2,6-difluorophenyl, bis(cyclopentadienyl)-Ti-bis-2,4-difluorophenyl, bis(methylcyclopentadienyl)-Ti-bis-2,3,4,5,6-pentafluorophenyl, bis(methylcyclopentadienyl)-Ti-bis-2,3,5,6-tetrafluorophenyl, bis(methylcyclopentadienyl)-Ti-bis-2,6-difluorophenyl (IRUGACURE 784, produced by Ciba Speciality Chemicals Co.), bis(cyclopentadienyl)-bis(2,4,6-trifluoro-3-(pyry-1-yl)phenyl)titanium, and bis(cyclopentadienyl)-bis(2,4,6-trifluoro-3-(2-5-dimethylpyry-1-yl)phenyl)titanium. As the monoalkyltriaryl borate compounds, there are those described in Japanese Patent O.P.I. Publication Nos. 62-150242 and 62-143044. Preferred examples of the monoalkyltriaryl borate compounds include tetra-n-butyl ammonium n-butyl-trinaphthalene-1-yl-borate, tetra-n-butyl ammonium n-butyl-triphenyl-borate, tetra-n-butyl ammonium n-butyl-tri-(4-tert-butylphenyl)-borate, tetra-n-butyl ammonium n-hexyl-tri-(3-chloro-4-methylphenyl)-borate, and tetra-n-butyl ammonium n-hexyl-tri-(3-fluorophenyl)-borate.

As the iron-arene complexes, there are those disclosed in Japanese Patent O.P.I. Publication No. 59-219307.

Preferred examples of the iron-arene complex include η-benzene-(η-cyclopentadienyl)iron hexafluorophosphate, η-cumene-(η-cyclopentadienyl)iron hexafluorophosphate, η-fluorene-(η-cyclopentadienyl)iron hexafluorophosphate, η-naphthalene-η-cyclopentadienyl)iron hexafluorophosphate, η-xylene-η-cyclopentadienyl)iron hexafluorophosphate, and η-benzene-η-cyclopentadienyl)iron tetrafluorophosphate.

As the polyhalogenated compound is preferably used a compound having a trihalomethyl group, a dihalomethyl group or a dihalomethylene group. A halogen compound represented by the following formula (1) or a compound having in the oxadiazole ring the group described above as the substituent or is more preferably used.

Among these, a halogen compound represented by the following formula (2) is especially preferably used.

Formula (1)

R¹-CY₂ (C=O) -R²
wherein R¹ represents a hydrogen atom, a halogen atom, an alkyl group, an aryl group, an acyl group, an alkylsulfonyl group, an arylsulfonyl group, an iminosulfo group or a cyano group; R² represents a monovalent substituent, provided that R¹ and R² may combine with each other to form a ring; and Y represents a halogen atom.

Formula (2)

CY₃-(C=O)-X-R³
wherein R³ represents a monovalent substituent; X represents -2- RU -15⁴- in which R⁴ represents a hydrogen atom or an alkyl group, provided that R³ and R⁴ may combine with each other to form a ring; and Y represents a halogen atom.

Among these, those having a polyhaloacetylamido group are preferably used.

A compound having in the oxadiazole ring a polyhalomethyl group as the substituent is preferably used. An oxadiazole compound disclosed in Japanese Patent O.P.I. Publication Nos. 5-34904 and 8-240909 also is preferably used.

The biimidazole compounds are imidazole derivatives, and examples thereof those disclosed in for example, Japanese Patent O.P.I. Publication No. 2003-295426.

In the invention, a hexaarylbisimidazole (HABI, a dimer of a triarylimidazole) compound can be preferably used as the biimidazole compound.

The synthetic method of HABI is disclosed in DE 1470154, and use thereof in a photopolymerizable composition is disclosed in EP 24629, EP 107792, US 4410621, EP 215453 and DE 321312.

Preferred examples of the derivatives include 2,4,5,2',4',5'-hH[DShHnyOELsLPLGD]ROH, 2,2'-ELs(2-FhORURShHnyO)-4,5,4',5'-tHtUDShHnyOELsLPLGD]ROH, 2,2'-ELs(2-EURPRShHnyO)-4,5,4',5'-tHtUDShHnyOELsLPLGD]ROH, 2,2'-ELs(2,4-GLFhORURShHnyO)-4,5,4',5'-tHtUDShHnyOELsLPLGD]ROH, 2,2'-ELs(2-FhORURShHnyO)-4,5,4',5'-tHtUDNLs(3-PHthR[yShHnyO)ELsLPLGD]ROH, 2,2'-ELs(2-FhORURShHnyO)-4,5,4',5'-tHtUDNLs(3,4,5-tULPHthR[yShHnyO)ELsLPLGD]ROH, 2,5,2',5'-tHtUDNLs(2-FhORURShHnyO)-4,4'-ELs(3,4-GLPHthR[yShHnyO)ELsLPLGD]ROH, 2,2'-ELs(2,6-GLFhORURShHnyO)-4,5,4',5'-tHtUDShHnyOELsLPLGD]ROH, 2,2'-ELs(2-nLtURShHnyO)-4,5,4',5'-tHtUDShHnyOELsLPLGD]ROH, 2,2'-GL-R-tROyO-4,5,4',5'-tHtUDShHnyOELsLPLGD]ROH, 2,2'-ELs(2-HthR[yShHnyO)-4,5,4',5'-tHtUDShHnyOELsLPLGD]ROH, DnG 2,2'-ELs(2,6-GLIOXRURShHnyO)-4,5,4',5'-tHtUDShHnyOELsLPLGD]ROH.

Another photopolymerization initiator can be used in combination. Examples thereof include carbonyl compounds, organic sulfur compounds, peroxides, redox compounds, azo or diazo compounds, halides and photo-reducing dyes disclosed in -. .RsDU, "LLJht 6HnsLtLYH 6ystHPs", 3DUDJUDSh 5, DnG thRsH disclosed in British Patent No. 1,459,563.

As the photopolymerization initiator used in combination, there are compounds described below.

A benzoin derivative such as benzoin methyl ether, benzoin i-propyl ether, or a,a-GLPHthR[y-a-phenylacetophenone; a benzophenone derivative such as benzophenone, 2,4-dichlorobenzophenone, o-benzoyl methyl EHn]RDtH, RU 4,4'-ELs (GLPHthyODPLnR) EHn]RShHnRnH; D thioxanthone derivative such as 2-chlorothioxanthone, 2-i-propylthioxanthone; an anthraquinone derivative such as 2-chloroanthraquinone or 2-methylanthraquinone; an acridone derivative such as N-methylacridone or N-butylacridone; a,a-diethoxyacetophenone; benzil; fluorenone; xanthone; an uranyl compound; a triazine derivative disclosed in Japanese Patent Publication Nos. 59-1281 and 61-9621 and Japanese Patent O.P.I. Publication No. 60-60104; an organic peroxide compound disclosed in Japanese Patent O.P.I. Publication Nos. 59-1504 and 61-243807; a diazonium compound in Japanese Patent Publication Nos. 43-23684, 44-6413, 47-1604 and US Patent No. 3,567,453; an organic azide compound disclosed in US Patent Nos. 2,848,328, 2,852,379 and 2,940,853; orthoquinondiazide compounds disclosed in Japanese Patent Publication Nos. 36-22062b, 37-13109, 38-18015 and 45-9610; various onium compounds disclosed in Japanese Patent Publication No. 55-39162, Japanese Patent O.P.I. Publication No. 59-14023 and "0DFURPROHFXOHs", 9ROXPH 10, S. 1307 (1977); D]R FRPSRXnGs disclosed in Japanese Patent Publication No. 59-142205; metal arene complexes disclosed in Japanese Patent O.P.I. Publication No. 1-54440, European Patent Nos. 109,851 and 126,712, DnG "-RXUnDO RI, PDJLnJ 6FLHnFH", 9ROXPH 30, S. 174 (1986); (oxo) sulfonium organoboron complexes disclosed in Japanese Patent O.P.I. Publication Nos. 5-213861 and 5-255347; titanocenes disclosed in Japanese Patent O.P.I. Publication Nos. 59-152396 and 61-151197; transition metal complexes containing a transition metal such as ruthenium GLsFORsHG Ln "CRRUGLnDtLRn ChHPLstUy 5HYLHw", 9ROXPH 84, S. 85-277 (1988) and Japanese Patent O.P.I. Publication No. 2-182701; 2,4,5-triarylimidazol dimmer disclosed in Japanese Patent O.P.I. Publication No. 3-209477; carbon tetrabromide; organic halide compounds disclosed in Japanese Patent O.P.I. Publication No. 59-107344.

The content of the polymerization initiator (total content of the polymerization initiator used) in the light-sensitive layer is preferably from 0.1 to 20% by weight, and more preferably from 0.5 to 15% by weight, based on the weight of polymerizable ethylenically unsaturated compound used.

### Polymerizable Ethylenically Unsaturated Compound (B)

The polymerizable ethylenically unsaturated compound (B) in the invention is a compound having an ethylenic double bond capable of undergoing polymerization due to a photopolymerization initiator contained in the image formation layer imagewise exposed.

As the ethylenically unsaturated compound, there are a known monomer such as a conventional radically polymerizable monomer and a polyfunctional monomer or oligomer having two or more of an ethylenic double bond in the molecule generally used in a conventional ultraviolet curable resin composition. The monomers are not specifically limited. Typical examples thereof include a monofunctional acrylate such as 2-ethylhexyl acrylate, 2-hydroxypropyl acrylate, glycerol acrylate, tetrahydrofurfuryl acrylate, phenoxyethyl acrylate, nonylphenoxyethyl acrylate, tetrahydrofurfuryl-oxyethyl acrylate, tetrahydrofurfuryloxyhexanorideacrylate, an ester of 1,3-dioxane-ε-caprolactone adduct with acrylic acid, or 1,3-dioxolane acrylate; a methacrylate, itaconate, crotonate or maleate alternative of the above acrylate; a bifunctional acrylate such as ethyleneglycol diacrylate, triethyleneglycol diacrylate, pentaerythritol diacrylate, hydroquinone diacrylate, resorcin diacrylate, hexanediol diacrylate, neopentyl glycol diacrylate, tripropylene glycol diacrylate, hydroxypivalic acid neopentyl glycol diacrylate, neopentyl glycol adipate diacrylate, diacrylate of hydroxypivalic acid neopentyl glycol-ε-caprolactone adduct, 2-(2-hydroxy-1,1-dimethylethyl)-5-hydroxymethyl-5-ethyl-1,3-dioxane diacrylate, tricyclodecanedimethylol acrylate, tricyclodecanedimethylol acrylate-ε-caprolactone adduct or 1,6-hexanediol diglycidylether diacrylate; a dimethacrylate, diitaconate, dicrotonate or dimaleate alternative of the above diacrylate; a polyfunctional acrylate such as trimethylolpropane triacrylate, ditrimethylolpropane tetraacrylate, trimethylolethane triacrylate, pentaerythritol triacrylate, pentaerythritol tetraacrylate, dipentaerythritol tetraacrylate, dipentaerythritol pentaacrylate, dipentaerythritol hexacrylate, dipentaerythritol hexacrylate-ε-caprolactone adduct, pyrrogallol triacrylate, propionic acid dipentaerythritol triacrylate, propionic acid dipentaerythritol tetraacrylate or hydroxypivalylaldehyde modified dimethylolpropane triacrylate; a methacrylate, itaconate, crotonate or maleate alternative of the above polyfunctional acrylate.

A prepolymer can be used, and examples of the prepolymer include compounds as described later. The prepolymer with a photopolymerizable property, which is obtained by incorporating acrylic acid or methacrylic in an oligomer with an appropriate molecular weight, can be suitably employed. These prepolymers can be used singly, in combination or as their mixture with the above described monomers andLor oligomers.

Examples of the prepolymer include polyester (meth)acrylate obtained by incorporating (meth)acrylic acid in a polyester of a polybasic acid such as adipic acid, trimellitic acid, maleic acid, phthalic acid, terephthalic acid, hymic acid, malonic acid, succinic acid, glutaric acid, itaconic acid, pyromellitic acid, fumalic acid, pimelic acid, sebatic acid, dodecanic acid or tetrahydrophthalic acid with a polyol such as ethylene glycol, ethylene glycol, diethylene glycol, propylene oxide, 1,4-butane diol, triethylene glycol, tetraethylene glycol, polyethylene glycol, grycerin, trimethylol propane, pentaerythritol, sorbitol, 1,6-hexanediol or 1,2,6-hexanetriol; an epoxyacrylate such as ELsShHnRO A-HSLFhORUhyGULn-(PHth)DFUyOLF DFLG RU ShHnRO nRYRODN-HSLFhORUhyGULn-(PHth)DFUyOLF DFLG REtDLnHG Ey incorporating (meth)acrylic acid in an epoxy resin; an XUHthDnHDFUyODtH sXFh Ds HthyOHnH JOyFRO·DGLSLF DFLG·tROyOHnHGLLsRFyDnDtH·2-hyGUR[yHthyODFUyODtH, SROyHthyOHnH JOyFRO·tROyOHnHGLLsRFyDnDtH·2-hydroxyethylacrylate, hydroxyethylphthalyl PHthDFUyODtH·[yOHnHGLLsRFyDnDtH, 1,2-SROyEXtDGLHnHJOyFRO·tROyOHnHGLLsRFyDnDtH·2-hyGUR[yHthyODFUyODtH RU tULPHthyOROSURSDnH·SURSyOHnH JOyFRO·tROyOHnHGLLsRFyDnDtH·2-hyGUR[yHthyODFUyODtH, REtDLnHG by incorporating (meth)acrylic acid in an urethane resin; a silicone acrylate such as polysiloxane acrylate, or SROysLOR[DnH·GLLsRFyDnDtH-2-hyGUR[yHthyODFUyODtH; Dn DONyG modified acrylate obtained by incorporating a methacroyl group in an oil modified alkyd resin; and a spiran resin acrylate.

The light sensitive layer in the invention may contain a monomer such as a phosphazene monomer, triethylene glycol, an EO modified isocyanuric acid diacrylate, an EO modified isocyanuric acid triacrylate, dimethyloltricyclodecane diacrylate, trimethylolpropane acrylate benzoate, an alkylene glycol acrylate, or a urethane modified acrylate, or an addition polymerizable oligomer or prepolymer having a structural unit derived from the above monomer.

The ethylenic monomer used in the invention is preferably a phosphate compound having at least one (meth)acryloyl group. The phosphate compound is a compound having a (meth)acryloyl group in which at least one hydroxyl group of phosphoric acid is esterified, and the phosphate compound is not limited as long as it has a (meth)acryloyl group.

Besides the above compounds, compounds disclosed in Japanese Patent O.P.I. Publication Nos. 58-212994, 61-6649, 62-46688, 62-48589, 62-173295, 62-187092, 63-67189, and 1-244891, FRPSRXnGs GHsFULEHG Rn SDJHs 286 tR 294 RI "11290 ChHPLFDO CRPSRXnGs" HGLtHG Ey .DJDNXNRJyR 1LSSRshD, DnG FRPSRXnGs GHsFULEHG Rn SDJHs 11 tR 65 RI "89. (% .RND HDnGERRN (0DtHULDOs)" HGLtHG Ey .REXnshL .DnNRNDL FDn EH sXLtDEOy used. Of these compounds, compounds having two or more acryl or methacryl groups in the molecule are preferable, and those having a molecular weight of not more than 10,000, and preferably not more than 5,000 are more preferable.

The image formation layer in the invention preferably contains an addition polymerizable ethylenically unsaturated compound having a tertiary amino group in the molecule, which is a tertiary amine monomer. Its molecular structure is not limited, but those are preferred in which a tertiary amine having a hydroxyl group is modified with glycidyl methacrylate, methacrylic chloride, or acrylic chloride. Examples thereof include a polymerizable compound disclosed in Japanese Patent O.P.I. Publication Nos. 1-165613, 1-203413 and 1-197213.

A reaction product of a polyhydric alcohol having a tertiary amino group in the molecule, a diisocyanate and a compound having a hydroxyl group and an addition polymerizable ethylenically double bond in the molecule is preferably used in the invention.

Examples of the polyhydric alcohol having a tertiary amino group in the molecule include triethanolamine, N-methyldiethanolamine, N-ethyldiethanolamine, N-ethyldiethanolamine, N-n-butyldiethanolamine, N-tert-EXtyOGLHthDnRODPLnH, 1,1-GL(hyGUR[yHthyO)DnLOLnH, 1,1, 1', 1'-tHtUD-2-hyGUR[ySURSyOHthyOHnHGLDPLnH, S-tROyOGLHthDnRODPLnH, 1,1, 1', 1'-tHtUD-2-hydroxyethylethylenediamine, N,N-bis(2-hydroxypropyl)aniline, allyldiethanolamine, 3-dimethylamino-1,2-propane diol, 3-diethylamino-1,2-propane diol, N,N-di(n-propylamino)-2,3-propane diol, N,N-di(iso-propylamino)-2,3-propane diol, and 3-(N-methyl-N-benzylamino)-1,2-propane diol, but the invention is not specifically limited thereto.

Examples of the diisocyanate include butane-1,4-diisocyanate, hexane-1,6-diisocyanate, 2-methylpentane-1,5-diisocyanate, octane-1,8-diisocyanate, 1,3-diisocyanatomethylcyclohexanone, 2,2,4-trimethylhexane-1,6-diisocyanate, isophorone diisocyanate, 1,2-phenylene diisocyanate, 1,3-phenylene diisocyanate, 1,4-phenylene diisocyanate, tolylene-2,4-diisocyanate, tolylene-2,5-diisocyanate, tolylene-2,6-diisocyanate, 1,3-di(isocyanatomethyl)benzene, and 1,3-bis(1-isocyanato-1-methylethyl)benzene, but the invention is not specifically limited thereto.

Examples of the compound having a hydroxyl group and an addition polymerizable ethylenically double bond in the molecule include include 2-hydroxyethyl methacrylate (MH-1), 2-hydroxyethyl acrylate (MH-2), 4-hydroxybutyl acrylate (MH-4), 2-hydroxypropylene-1,3-dimethacrylate (MH-7), and 2-hydroxypropylene-1-methacrylate-3-acrylate (MH-8).

The reaction product above can be synthesized according to the same method as a conventional method in which a urethaneacrylate compound is ordinarily synthesized employing an ordinary diol, a diisocyanate and an acrylate having a hydroxyl group.

Examples of the reaction product of a polyhydric alcohol having a tertiary amino group in the molecule, a diisocyanate and a compound having a hydroxyl group and an addition polymerizable ethylenically double bond in the molecule will be listed below.
M-1: A reaction product of triethanolamine (1 mole), hexane-1,6-diisocyanate (3 moles), and 2-hydroxyethyl methacrylate (3 moles)
M-2: A reaction product of triethanolamine (1 mole), isophorone diisocyanate (3 moles), and 2-hydroxyethyl methacrylate (3 moles)
M-3: A reaction product of N-n-butyldiethanolamine (1 mole), 1,3-bis(1-cyanato-1-methylethyl)benzene (2 moles), and 2-hydroxypropylene-l-methacrylate-3-acrylate (2 moles)
M-4: A reaction product of N-n-butyldiethanolamine (1 mole), 1,3-di(cyanatomethyl)benzene (2 moles), and 2-hydroxypropylene-l-methacrylate-3-acrylate (2 moles)
M-5: A reaction product of N-methydiethanolamine (1 mole), tolylene-2,4-diisocyanate (2 moles), and 2-hydroxypropylene-1,3-dimethacrylate (2 moles)

In addition to the above, acrylates or methacrylates disclosed in Japanese Patent O.P.I. Publication Nos. 1-105238 and 2-127404 can be used.

### Dye (C) having absorption maximum in the wavelength regions of from 350 to 450 nm

The image formation layer in the invention contains a dye (C) having absorption maximum in the wavelength regions of from 350 to 450 nm.

The method of measuring absorption spectrum of a dye is as follows. A dye solution in which the dye is dissolved in acetonitrile being placed in a quartz cell with an optical path length of 1 cm, absorbance in the wavelength regions of from 300 to 500 nm is measured employing a spectrophotometer. In the spectrophotometer, a general double beam or a single beam is used. As a reference sample or a sample of determining a base line, a quartz cell charged with acetonitrile is used. The dye concentration of the solution is adjusted so that maximum absorbance in the wavelength regions of from 350 to 450 nm is from 0.2 to 2.0. Presence of the absorption maximum in the wavelength regions of from 350 to 450 nm is confirmed from the results of the measurement.

Examples of the dyes include cyanine, merocyanine, oxonol, porphyrin, a spiro compound, ferrocene, fluorene, fulgide, imidazole, perylene, phenazine, phenothiazine, acridine, an azo compound, diphenylmethane, triphenylmethane, triphenylamine, cumarin derivatives, quinacridone, indigo, styryl, pyrylium compounds, pyrromethene compounds, pyrazolotriazole compounds, benzothiazole compounds, barbituric acid derivatives, thiobarbituric acid derivatives, and ketoalcohol borate complexes.

As the coumarin derivatives described above, there are, for example, coumarin derivatives B-1 through B-22 disclosed in Japanese Patent O.P.I. Publication No. 8-129258, coumarin derivatives D-1 through D-32 disclosed in Japanese Patent O.P.I. Publication No. 2003-12901, coumarin derivatives 1 through 21 disclosed in Japanese Patent O.P.I. Publication No. 2002-363206, coumarin derivatives 1 through 40 disclosed in Japanese Patent O.P.I. Publication No. 2002-363207, coumarin derivatives 1 through 34 disclosed in Japanese Patent O.P.I. Publication No. 2002-363208, coumarin derivatives 1 through 56 disclosed in Japanese Patent O.P.I. Publication No. 2002-363209, which are preferably used.

As other preferred dyes, there are, for example, sensitizing dyes disclosed in Japanese Patent O.P.I. Publication Nos. 2000-98605, 2000-147763, 2000-206690, 2000-258910, 2000-309724, 2001-042524, 2002-202598, and 2000-221790.

### Polymeric Binder (D)

The polymeric binder in the invention is one capable of carrying components contained in the image formation layer on a support. As examples thereof, there is a polyacrylate resin, a polyvinylbutyral resin, a polyurethane resin, a polyamide resin, a polyester resin, an epoxy resin, a phenol resin, a polycarbonate resin, a polyvinyl butyral resin, a polyvinyl formal resin, a shellac resin or another natural resin. These resins can be used as an admixture of two or more thereof.

The polymeric binder used in the invention is preferably a vinyl copolymer obtained by copolymerization of an acryl monomer, and more preferably a copolymer containing (a) a carboxyl group-containing monomer unit and (b) an alkyl methacrylate or alkyl acrylate unit as the copolymerization component.

Examples of the carboxyl group-containing monomer include an α,β-unsaturated carboxylic acid, for example, acrylic acid, methacrylic acid, maleic acid, maleic anhydride, itaconic acid, itaconic anhydride or a carboxylic acid such as a half ester of phthalic acid with 2-hydroxymethacrylic acid.

Examples of the alkyl methacrylate or alkyl acrylate include an unsubstituted alkyl ester such as methylmethacrylate, ethylmethacrylate, propylmethacrylate, butylmethacrylate, amylmethacrylate, hexylmethacrylate, heptylmethacrylate, octylmethacrylate, nonylmethacrylate, decylmethacrylate, undecylmethacrylate, dodecylmethacrylate, methylacrylate, ethylacrylate, propylacrylate, butylacrylate, amylacrylate, hexylacrylate, heptylacrylate, octylacrylate, nonylacrylate, decylacrylate, undecylacrylate, or dodecylacrylate; a cyclic alkyl ester such as cyclohexyl methacrylate or cyclohexyl acrylate; and a substituted alkyl ester such as benzyl methacrylate, 2-chloroethyl methacrylate, N,N-dimethylaminoethyl methacrylate, glycidyl methacrylate, benzyl acrylate, 2-chloroethyl acrylate, N,N-dimethylaminoethyl acrylate or glycidyl acrylate.

The polymeric binder in the invention can further contain, as another monomer unit, a monomer unit derived from the monomer described in the following items (1) through (14):
(1) A monomer having an aromatic hydroxy group, for example, o-, (p- or m-) hydroxystyrene, or o-, (p- or m-) hydroxyphenylacrylate;
(2) A monomer having an aliphatic hydroxy group, for example, 2-hydroxyethyl acrylate, 2-hydroxyethyl methacrylate, N-methylolacrylamide, N-methylolmethacrylamide, 4-hydroxybutyl acrylate, 4-hydroxybutyl methacrylate, 5-hydroxypentyl acrylate, 5-hydroxypentyl methacrylate, 6-hydroxyhexyl acrylate, 6-hydroxyhexyl methacrylate, N-(2-hydroxyethyl)acrylamide, N-(2-hydroxyethyl)methacrylamide, or hydroxyethyl vinyl ether;
(3) A monomer having an aminosulfonyl group, for example, m- or p-aminosulfonylphenyl methacrylate, m- or p-aminosulfonylphenyl acrylate, N-(p-aminosulfonylphenyl) methacrylamide, or N-(p-aminosulfonylphenyl)acrylamide;
(4) A monomer having a sulfonamido group, for example, N-(p-toluenesulfonyl)acrylamide, or N-(p-toluenesulfonyl)-methacrylamide;
(5) An acrylamide or methacrylamide, for example, acrylamide, methacrylamide, N-ethylacrylamide, N-hexylacrylamide, N-cyclohexylacrylamide, N-phenylacrylamide, N-nitrophenylacrylamide, N-ethyl-N-phenylacrylamide, N-4-hydroxyphenylacrylamide, or N-4-hydroxyphenylmethacrylamide;
(6) A monomer having a fluorinated alkyl group, for example, trifluoromethyl acrylate, trifluoromethyl methacrylate, tetrafluoropropyl methacrylate, hexafluoropropyl methacrylate, octafluoropentyl acrylate, octafluoropentyl methacrylate, heptadecafluorodecyl methacrylate, heptadecafluorodecyl methacrylate, or N-butyl-N-(2-acryloxyethyl)heptadecafluorooctylsulfonamide;
(7) A vinyl ether, for example, ethyl vinyl ether, 2-chloroethyl vinyl ether, propyl vinyl ether, butyl vinyl ether, octyl vinyl ether, or phenyl vinyl ether;
(8) A vinyl ester, for example, vinyl acetate, vinyl chroloacetate, vinyl butyrate, or vinyl benzoate;
(9) A styrene, for example, styrene, methylstyrene, or chloromethystyrene;
(10) A vinyl ketone, for example, methyl vinyl ketone, ethyl vinyl ketone, propyl vinyl ketone, or phenyl vinyl ketone;
(11) An olefin, for example, ethylene, propylene, isobutylene, butadiene, or isoprene;
(12) N-vinylpyrrolidone, N-vinylcarbazole, or N-vinylpyridine,
(13) A monomer having a cyano group, for example, acrylonitrile, methacrylonitrile, 2-pentenenitrile, 2-methyl-3-butene nitrile, 2-cyanoethyl acrylate, or o-, m- or p-cyanostyrene;
(14) A monomer having an amino group, for example, N,N-diethylaminoethyl methacrylate, N,N-dimethylaminoethyl acrylate, N,N-dimethylaminoethyl methacrylate, polybutadiene urethane acrylate, N,N-dimethylaminopropyl acrylamide, N,N-dimethylacrylamide, acryloylmorpholine, N-isopropylacrylamide, or N,N-diethylacrylamide.

Further another monomer may be copolymerized with the above monomer.

The polymeric binder is preferred which has, in the side chain of the molecule, both carboxyl group and polymerizable double bond. For example, an unsaturated bond-containing copolymer is preferred which is obtained by reacting a carboxyl group contained in the above vinyl copolymer molecule with for example, a compound having a (meth)acryloyl group and an epoxy group.

Examples of the compound having a double bond and an epoxy group in the molecule include glycidyl acrylate, glycidyl methacrylate and an epoxy group-containing unsaturated compound disclosed in Japanese Patent 0. P. I . Publication No. 11-27196. Further, an unsaturated bond-containing copolymer which is obtained by reacting a hydroxyl group contained in the above vinyl copolymer molecule with for example, a compound having a (meth)acryloyl group and an isocyanate group. Examples of the compound having a (meth)acryloyl group and an isocyanate group in the molecule include vinyl isocyanate, (meth)acryl isocyanate, 2-(meth)acroyloxyethyl isocyanate, m- or p-isopropenyl-α,α'-dimethylbenzyl isocyanate, and (meth)acryl isocyanate, or 2-(meth)acroyloxyethyl isocyanate is preferred.

The content of the polymeric binder having in the side chain of the molecule both carboxyl group and polymerizable double bond in the light sensitive layer is preferably from 50 to 100% by weight, and more preferably 100% by weight, based on the total content of the polymeric binder contained in the light sensitive layer.

The content of the polymeric binder in the light sensitive layer is preferably from 10 to 90% by weight, more preferably from 15 to 70% by weight, and still more preferably from 20 to 50% by weight, in view of sensitivity.

### (sarious additives)

The light sensitive layer in the invention is preferably added with a polymerization inhibitor, in order to prevent undesired polymerization of the ethylenically unsaturated compound during the manufacture or after storage of light sensitive planographic printing plate material.

Examples of the polymerization inhibitor include hydroquinone, p-methoxyphenol, di-t-butyl-p-cresol, SyUURJDOORO, t-EXtyOFDtHFhRO, EHn]RTXLnRnH, 4,4'-thLRELs (3-PHthyO-6-t-EXtyOShHnRO), 2,2'-PHthyOHnHELs (4-PHthyO-6-t-butylphenol), N-nitrosophenylhydroxylamine cerous salt, and 2-t-butyl-6-(3-t-butyl-6-hydroxy-5-mrthylbenzyl)-4-methylphenyl acrylate.

The polymerization inhibitor content is preferably 0.01 to 5% by weight based on the total solid content of the light sensitive layer. Further, in order to prevent undesired polymerization induced by oxygen, behenic acid or a higher fatty acid derivative such as behenic amide may be added to the layer. After the light sensitive layer is coated layer, the coated layer may be dried so that the higher fatty acid derivative is localized at the vicinity of the surface of the light sensitive layer. The content of the higher fatty acid derivative is preferably 0.5 to 10% by weight, based on the total solid content of the light sensitive layer.

A colo-rant can be also used. As the colorant can be used known materials including commercially available materials. Examples of the colorant include those described Ln UHYLsHG HGLtLRn "GDnUyR %LnUDn", HGLtHG Ey 1LSSRn GDnUyR GLMXtX .yRXNDL (SXEOLshH Ey 6HLEXnnGRX 6LnNRshD), RU "CRORU ,nGH[ %LnUDn". 3LJPHnt Ls SUHIHUUHG. hinds of the pigment include black pigment, yellow pigment, red pigment, brown pigment, violet pigment, blue pigment, green pigment, fluorescent pigment, and metal powder pigment. Examples of the pigment include inorganic pigment (such as titanium dioxide, carbon black, graphite, zinc oxide, Prussian blue, cadmium sulfide, iron oxide, or chromate of lead, zinc, barium or calcium); and organic pigment (such as azo pigment, thioindigo pigment, anthraquinone pigment, anthanthrone pigment, triphenedioxazine pigment, vat dye pigment, phthalocyanine pigment or its derivative, or quinacridone pigment).

Among these pigment, pigment is preferably used which does not substantially have absorption in the absorption wavelength regions of a spectral sensitizing dye used according to a laser for exposure. The absorption of the pigment used is not more than 0.05, obtained from the reflection spectrum of the pigment measured employing an integrating sphere and employing light with the wavelength of the laser used. The pigment content is preferably 0.1 to 10% by weight, and more preferably 0.2 to 5% by weight, based on the total solid content of the photopolymerizable light sensitive layer composition.

A purple pigment or a blue pigment is preferably utilized in view of absorption of light with the aforesaid photosensitive wavelength region and image visibility after development. Such pigments include, for example, Cobalt Blue, cerulean blue, Alkali Blue, Phonatone Blue 6G, sictoria Blue Lake, metal-free Phthalocyanine Blue, Phthalocyanine Fast Sky Blue, Indathrene Blue, indigo, Dioxane siolet, Isoviolanthrone siolet, Indanthrone Blue and Indanthrone BC. Among them, more preferable are Phthalocyanine Blue and Dioxane siolet.

The light sensitive layer can contain surfactants as a coating improving agent as long as the performance of the invention is not jeopardized. Among these surfactants, a fluorine-contained surfactant is preferred.

Further, in order to improve physical properties of the cured light sensitive layer, the layer can contain an inorganic filler or a plasticizer such as dioctyl phthalate, dimethyl phthalate or tricresyl phosphate. The content of such a material is preferably not more than 10% by weight, based on the total solid content of the light sensitive layer.

The solvents used in the preparation of the coating solution for the light sensitive layer in the invention include an alcohol such as sec-butanol, isobutanol, n-hexanol, or benzyl alcohol; a polyhydric alcohol such as diethylene glycol, triethylene glycol, tetraethylene glycol, or 1,5-pentanediol; an ether such as propylene glycol monobutyl ether, dipropylene glycol monomethyl ether, or tripropylene glycol monomethyl ether; a ketone or aldehyde such as diacetone alcohol, cyclohexanone, or methyl cyclohexanone; and an ester such as ethyl lactate, butyl lactate, diethyl oxalate, or methyl benzoate.

In the above, explanation of a light sensitive layer coating solution was made. The light sensitive layer in the invention is formed on a support by coating on the support the light sensitive layer coating solution.

The coating amount of the light sensitive layer is preferably from 0.1 to 10 gLm², and more preferably from 0.5 to 5 gLm².

### Protective layer (E)

The protective layer in the invention is a layer provided on the light sensitive layer in the invention, and contains a dye precursor (F) capable of changing to a dye absorbing light with a wavelength of from 350 to 450 nm by heating. A layer provided on the light sensitive layer means one provided on the surface of the light sensitive layer on a support opposite the support.

The dye precursor capable of changing to a dye absorbing light with a wavelength of from 350 to 450 nm by heating means a precursor capable of changing to a dye absorbing light with a wavelength of from 350 to 450 nm by heating the protective layer after imagewise exposure.

As a method of heating the imagewise exposed planographic printing plate material, there are a method in which the planographic printing plate material is brought into contact with gas such as heated air, a method in which one surface or both surfaces of the planographic printing plate material are brought into contact with a heated member such as a heated roller, and a method in which the entire surface of the planographic printing plate material is exposed to infrared rays.

The heating temperature is preferably from 50 to 200 °C, DnG PRUH SUHIHUDEOy IURP 80 tR 150 °C. 7hH hHDtLnJ period is preferably from 1 to 360 seconds, and more preferably from 5 to 60 seconds.

It is preferred that the heating is carried out after imagewise exposure and before the plate-making process which follows.

As the dye precursor in the invention, there is mentioned a compound forming a dye on reaction with for example, a color-developing agent (G) described later or a compound changing the absorption wavelength regions due to change of steric configuration by action of heat.

As the compound as described above forming a dye on reaction with a color-developing agent, an electron providing dye precursor is preferably used.

As the electron providing dye precursor, known materials used in a thermosensitive recording sheet can be used.

There are, for example, triarylmethane type compounds represented by crystal violet lactone, diphenylmethane type compounds such as leuoauramines, spiropyran type compounds, fluoran type compounds, rhodamine lactam type compounds, and carbazolylmethane type compounds.

Compounds represented by formula (1) as disclosed in Japanese Patent O.P.I. Publication No. 6-210947 can be also used.

Examples of the dye precursor used in the invention will be listed below.
(1) Triarylmethane-type compound
   3,3-bis(p-dimethylaminophenyl)-6-dimethylaminophthalide (crystal violet lactone), 3,3-bis(p-dimethylaminophenyl)-phthalide, 3-(p-dimethylaminophenyl)-3-(1,2-dimethylindole-3-yl)phthalide, 3-(p-dimethylaminophenyl)-3-(2-methylindole-3-yl)phthalide, 3-(p-dimethylaminophenyl)-3-(2-phenylindole-3-yl)phthalide, 3,3-bis(1,2-dimethylindole-3-yl)-5-dimethylaminophthalide, 3,3-bis(1,2-dimethylindole-3-yl)-6-dimethylaminophthalide, 3,3-bis(9-ethylcarbazole-3-yl)-5-dimethylaminophthalide, 3,3-bis(2-phenylindole-3-yl)-5-dimethylaminophthalide, 3-p-dimethylaminophenyl-3-(1-methylpyrrole-2-yl)-6-dimethylaminophthalide, and the like.
(2) Diphenylmethane-type compound
   4,4'-ELs-GLPHthyODPLnRShHnyOEHn]hyGUy OEHn]yO HthHU, 1-halophenyl leucoauramine, 2,4,5-trichlorophenyl leucoauramine, and the like.
(3) Xanthene-type compound
   rhodamine B anilinolactam, rhodamine B-p-chloroanilinolactam, 3--diethylamino-7-dibenzylaminofluoran, 3-diethylamino-7-octylaminofluoran, 3-diethylamino-7-phenylfluoran, 3-diethylamino-7-chlorofluoran, 3-diethylamino-6-chloro-7-methylfluoran, 3-diethylamino-7-(3,4-dichloroanilino)fluoran, 3-diethylamino-7-(2-chloroanilino)fluoran, 3-diethylamino-6-methyl-7-anilinofluoran, 3-(N-ethyl-N-tolyl)amino-6-methyl-7-anilinofluoran, 3-piperizino-6-methyl-7-anilinofluoran, 3-(N-ethyl-N-tolyl)amino-6-methyl-7-phenethylfluoran, 3-diethylamino-7-(4-nitroanilino)fluoran, 3-dibutylamino-6-methyl-7-anilinofluoran, 3-(N-methyl-N-propyl)amino-6-methyl-7-anilinofluoran, 3-(N-ethyl-N-isoamyl)amino-6-methyl-7-anilinofluoran, 3-(N-ethyl-N-cyclohexyl)amino-6-methyl-7-anilinofluoran, 3-(N-ethyl-N-tetrahydrofuryl)amino-6-methyl-7-anilinofluoran, and the like.
(4) Thiazine-type compound
   benzoyl leuco methylene blue, p-nitrobenzoyl leuco methylene blue, and the like.
(5) Spiro-type compound
   3-methylspiro-dinaphthopyran, 3-ethylspiro-GLnDShthRSyUDn, 3,3'-GLFhORURsSLUR-GLnDShthRSyUDn, 3-EHn]yO-spiro-dinaphthopyran, 3-methyl-naphtho-(3-methoxybenzo)spiropyran, 3-propylspiro-benzopyran, and the like.

These may be used singly or as an admixture of two or more kinds thereof.

As the color-developing agent used in combination with the dye precursors described above, there can be used organic or inorganic compounds, which are known as so-called color-developing agents. Among these are preferred organic electron-accepting color-developing agents.

As the organic electron accepting color-developing agents, known agents, which are used in a conventional thermal recording paper and disclosed in Japanese Patent O.P.I. Publication Nos. 6-99663, 7-52551, and 8-258420, can be preferably used.

For example, include acidic compounds such as a phenol compound, a thiophenol compound, a thiourea derivative, an organic acid or its metal salt, and oxyesters are preferably used.

([DPSOHs thHUHRI LnFOXGH ELsShHnROs sXF Ds 2,2-ELs(4'-hyGUR[yShHnyO)SURSDnH (FDOOHG ELsShHnRO A), 2,2-ELs(4'-hyGUR[yShHnyO)SHntDnH, 2,2-ELs(4'-hyGUR[y-3',5'-GLFhORURShHnyO)SURSDnH, 1,1-ELs(4'-hyGUR[yShHnyO)FyFORhH[DnH, 2,2-ELs(4'-hyGUR[yShHnyO)hH[DnH, 1,1-ELs(4'-hyGUR[yShHnyO)SURSDnH, 1,1-ELs(4'-hyGUR[yShHnyO)EXtDnH, 1,1-ELs(4'-hyGUR[yShHnyO)SHntDnH, 1,1-ELS(4'-hyGUR[yShHnyO)hH[DnH, 1,1-ELs(4'-hyGUR[yShHnyO)hHStDnH, 1,1-ELs(4'-hyGUR[yShHnyO)RFtDnH, 1,1-ELs(4'-hyGUR[yShHnyO)-2-PHthyOSHntDnH, 1,1-ELs(4'-hyGUR[yShHnyO)-2-HthyOhH[DnH, 1,1-ELs(4'-hyGUR[yShHnyO)GRGHFDnH, 1,4-ELs(S-hydroxyphenylcumyl)benzene, 1,3-bis(p-hydroxyphenylcumyl)benzene, bis(p-hydroxyphenyl)sulfone, bis(3-allyl-4-hydroxyphenyl)sulfone, and bis(p-hydroxyphenyl)acetic acid benzyl ester; salicylic acid derivatives such as 3,5-di-a-methylbenzylsalicylic acid, 3,5-di-t-butylsalicylic acid, 3-α,α-dimethylbenzylsalicylic acid, 4-(β-p-dimethoxyphenoxyethoxy)salicylic acid and their polyvalent metal (particularly, zinc, aluminum is preferred) salts; oxybenzoic acid esters such as p-hydroxybenzoic acid benzyl ester, p-hydroxybenzoic acid 2-ethylhexyl ester, and β-resorcylic acid-(2-phenoxyethyl) ester; and phenols such as p-phenylphenol, 3,5-diphenylphenol, cumylphenol, 4-hydroxy-4'-LsRSURSR[y-GLShHnyO sXOIRnH, DnG 4-hyGUR[y-4'-ShHnR[y-diphenyl sulfone, but are not limited thereto.

Incorporation of the dye precursor in the protective layer improves safelight property, particularly safelight property in the process from a plate-making step including imagewise exposure and developing till a printing step.

This prevents stain occurrence during printing.

The dye precursor content of the protective layer is preferably from 0.1 to 20% by weight, and more preferably from 0.5 to 10% by weight, based on the total weight of the protective layer.

The color-developing agent content of the protective layer is preferably from 0.1 to 20% by weight, and more preferably from 0.5 to 10% by weight, based on the total weight of the protective layer.

The content ratio of the dye precursor to the color-developing agent (dye precursorL color-developing agent by weight ratio) is preferably from 0.1 to 10.

In order to accelerate (or restrain) reaction of the dye precursor and the color-developing agent, the protective layer can contain a sensitizing agent such as benzyl bisphenol or benzyloxynaphthalene; a pH adjusting agent such as an acid or an alkali; and an anti-oxidant such as hindered phenols.

The protective layer in the invention preferably contains a polymer binder capable of carrying the dye precursor.

As the polymer binder, polyvinyl alcohol and polyvinyl pyrrolidone are preferably used in preventing oxygen from transmitting or in increasing adhesion between the oxygen shielding layer and the light sensitive layer.

Besides the above two polymers, the oxygen shielding layer may contain a water soluble polymer such as polysaccharide, polyethylene glycol, gelatin, glue, casein, hydroxyethyl cellulose, carboxymethyl cellulose, methyl cellulose, hydroxyethyl starch, gum arabic, sucrose octacetate, ammonium alginate, sodium alginate, polyvinyl amine, polyethylene oxide, polystyrene sulfonic acid, polyacrylic acid, or a water soluble polyamide.

The protective layer is provided on the light sensitive layer so that adhesive strength between the protective layer and the light sensitive layer is preferably not less than 35 mNLmm, more preferably not less than 50 mNLmm, and still more preferably not less than 75 mNLmm.

The protective layer may further contain a surfactant or a matting agent. The protective layer can be formed, coating on the light sensitive layer a coating solution in which the components to be contained in the protective layer are dissolved in a solvent, and drying.

The main solvent of the coating solution is preferably water or an alcohol solvent such as methanol, ethanol, or iso-propanol.

The thickness of the protective layer is preferably 0.1 tR 5.0 µP, DnG PRUH SUHIHUDEOy 0.5 tR 3.0 µP.

The protective layer in the invention preferably contains a light-to-heat conversion material when the heating in the invention is carried out employing infrared rays.

As the light-to-heat conversion material, there are an infrared absorbing dye and pigment.

### (Infrared absorbing dye)

Examples of the infrared absorbing dye include a cyanine dye, a chloconium dye, a polymethine dye, an azulenium dye, a squalenium dye, a thiopyrylium dye, a naphthoquinone dye or an anthraquinone dye, and an organometallic complex such as a phthalocyanine compound, a naphthalocyanine compound, an azo compound, a thioamide compound, a dithiol compound or an indoaniline compound. Exemplarily, the light-to-heat conversion materials include those disclosed in Japanese Patent O.P.I. Publication Nos. 63-139191, 64-33547, 1-160683, 1-280750, 1-293342, 2-2074, 3-26593, 3-30991, 3-34891, 3-36093, 3-36094, 3-36095, 3-42281, 3-97589, 3-103476, 7-43851, 7-102179, and 2001-117201. These compounds may be used singly or in combination.

As the pigment, there are carbon, graphite, a metal and a metal oxide.

Furnace black and acetylene black is preferably used as the carbon. The graininess (d₅₀) thereof is preferably not more than 100 nm, and more preferably not more than 50 nm.

The graphite is one having a particle size of SUHIHUDEOy nRt PRUH thDn 0.5 µP, PRUH SUHIHUDEOy nRt PRUH than 100 nm, and most preferably not more than 50 nm.

As the metal, any metal can be used as long as the metal is in a form of fine particles having preferably a SDUtLFOH sL]H RI nRt PRUH thDn 0.5 µP, PRUH SUHIHUDEOy nRt more than 100 nm, and most preferably not more than 50 nm. The metal may have any shape such as spherical, flaky and needle-like. Colloidal metal particles such as those of silver or gold are particularly preferred.

As the metal oxide, materials having black color in the visible regions or materials which are electro-conductive or semi-conductive can be used. Examples of the materials having black color in the visible regions include black iron oxide (Fe₃O₄) and black complex metal oxides containing at least two metals.

The content of the light-to-heat conversion material in the protective layer is from 0.1 to 50% by weight, preferably from 1 to 30% by weight, and more preferably from 3 to 25% by weight.

### (Support)

The support used in the invention is a plate or a sheet capable of carrying the light sensitive layer and preferably has a hydrophilic surface on the side on which the light sensitive layer is to be provided.

As the supports used in the invention, a plate of a metal such as aluminum, stainless steel, chromium or nickel, or a plastic film such as a polyester film, a polyethylene film or a polypropylene film, which is deposited or laminated with the above-described metal can be used.

Further, a polyester film, a polyvinyl chloride film or a nylon film whose surface is subjected to hydrophilization treatment can be used, and the aluminum support is preferably used.

As the aluminum support, a pure aluminum plate or an aluminum alloy plate is preferably used.

As the aluminum alloy for the support, there can be used various ones including an alloy of aluminum and a metal such as silicon, copper, manganese, magnesium, chromium, zinc, lead, bismuth, nickel, titanium, sodium or iron. In the aluminum plate for the support, the surface is roughened for water retention.

It is preferable that the aluminum plate is subjected to degreasing treatment for removing rolling oil prior to surface roughening (graining). The degreasing treatments include degreasing treatment employing solvents such as trichlene and thinner, and an emulsion degreasing treatment employing an emulsion such as kerosene or triethanol. It is also possible to use an aqueous alkali solution such as caustic soda for the degreasing treatment. then an aqueous alkali solution such as caustic soda is used for the degreasing treatment, it is possible to remove soils and an oxidized film which can not be removed by the above-mentioned degreasing treatment alone. then an aqueous alkali solution such as caustic soda is used for the degreasing treatment, the resulting support is preferably subjected to desmut treatment in an aqueous solution of an acid such as phosphoric acid, nitric acid, sulfuric acid, chromic acid, or a mixture thereof, since smut is produced on the surface of the support. The surface roughening methods include a mechanical surface roughening method and an electrolytic surface roughening method electrolytically etching the support surface.

Though there is no restriction for the mechanical surface roughening method, a brushing roughening method and a honing roughening method are preferable.

Though there is no restriction for the electrolytic surface roughening method, a method, in which the support is electrolytically surface roughened in an acidic electrolytic solution, is preferred.

After the support has been electrolytically surface roughened, it is preferably dipped in an acid or an aqueous alkali solution in order to remove aluminum dust, etc. produced in the surface of the support. Examples of the acid include sulfuric acid, persulfuric acid, hydrofluoric acid, phosphoric acid, nitric acid and hydrochloric acid, and examples of the alkali include sodium hydroxide and potassium hydroxide. Among those mentioned above, the aqueous alkali solution is preferably used.

The dissolution amount of aluminum in the support surface is preferably 0.5 to 5 gLm². After the support has been dipped in the aqueous alkali solution, it is preferable for the support to be dipped in an acid such as phosphoric acid, nitric acid, sulfuric acid and chromic acid, or in a mixed acid thereof, for neutralization.

The mechanical surface roughening and electrolytic surface roughening may be carried out singly, and the mechanical surface roughening followed by the electrolytic surface roughening may be carried out.

After the surface roughening, anodizing treatment may be carried out. There is no restriction in particular for the method of anodizing treatment used in the invention, and known methods can be used. The anodizing treatment forms an anodization film on the surface of the support.

The support which has been subjected to anodizing treatment is optionally subjected to sealing treatment. For the sealing treatment, it is possible to use known methods using hot water, boiling water, steam, a sodium silicate solution, an aqueous dichromate solution, a nitrite solution and an ammonium acetate solution.

After the above treatment, the support is suitably undercoated with a water soluble resin such as polyvinyl phosphonic acid, a polymer or copolymer having a sulfonic acid in the side chain, or polyacrylic acid; a water soluble metal salt such as zinc borate; a yellow dye; an amine salt; and so on, for hydrophilization treatment. The sol-gel treatment support disclosed in Japanese Patent O.P.I. Publication No. 5-304358, which has a functional group capable of causing addition reaction by radicals as a covalent bond, is suitably used.

### (Coating)

In the invention, the above-described light sensitive layer coating solution is coated on the support according to a coating conventional method, and dried to obtain a light sensitive planographic printing plate material.

Examples of the coating method include an air doctor coating method, a blade coating method, a wire bar coating method, a knife coating method, a dip coating method, a reverse roll coating method, a gravure coating method, a cast coating method, a curtain coating method, and an extrusion coating method.

A drying temperature of the coated light sensitive ODyHU Ls SUHIHUDEOy IURP 60 tR 160 °C, PRUH SUHIHUDEOy IURP 80 tR 140 °C, DnG stLOO PRUH SUHIHUDEOy IURP 90 tR 120 °C. (Imagewise Exposure)

As a light source for recording an image on the light sensitive planographic printing plate material of the invention, a laser with an emission wavelength of from 350 to 450 nm is preferably used.

Examples of light sources for imagewise exposure of the light sensitive planographic printing plate material include a He-Cd laser (441 nm), a combination of Cr:LiSAF and SHG crystals (430 nm) as a solid laser, and hnbO3, ring resonator (430 nm), AlGaInN (350-350 nm) or AlGaInN semiconductor laser (InGaN type semiconductor laser available on the market, 400-410 nm) as a semiconductor type laser.
then a laser is used for exposure, which can be condensed in the beam form, scanning exposure according to an image can be carried out, and direct writing is possible without using any mask material.
then the laser is employed for imagewise exposure, a highly dissolved image can be obtained, since it is easy to condense its exposure spot in minute size.

As a laser scanning method by means of a laser beam, there are a method of scanning on an outer surface of a cylinder, a method of scanning on an inner surface of a cylinder and a method of scanning on a plane. In the method of scanning on an outer surface of a cylinder, laser beam exposure is conducted while a drum around which a recording material is wound is rotated, in which main scanning is represented by the rotation of the drum, while sub-scanning is represented by the movement of the laser beam. In the method of scanning on an inner surface of a cylinder, a recording material is fixed on the inner surface of a drum, a laser beam is emitted from the inside, and main scanning is carried out in the circumferential direction by rotating a part of or an entire part of an optical system, while sub-scanning is carried out in the axial direction by moving straight a part of or an entire part of the optical system in parallel with a shaft of the drum. In the method of scanning on a plane, main scanning by means of a laser beam is carried out through a combination of a polygon mirror, a galvano mirror and an Fθ lens, and sub-scanning is carried out by moving a recording medium. The method of scanning on an outer surface of a cylinder and the method of scanning on an inner surface of a cylinder are suitable for high density image recording, since it is easier to increase accuracy of an optical system.

In the invention, imagewise exposure is carried out at a plate surface energy (an exposure energy at the surface of the planographic printing plate material) of from 10 to 500 mJLcm², and more preferably from 10 to 300 mJLcm². This exposure energy can be measured, employing a laser power meter PDGDO-3t produced by Ophir Optronics Inc.

### (Developer)

In the manufacturing method of the invention of a planographic printing plate, the imagewise exposed light sensitive layer, which has been cured at exposed portions, is developed with an alkali developer, whereby the light sensitive layer at exposed portions are removed to form an image.

As the developer above, a conventional alkali aqueous solution is used. For example, there is an alkali developer containing an inorganic alkali agent such as sodium silicate, potassium silicate, ammonium silicate, sodium secondary phosphate, potassium secondary phosphate, ammonium secondary phosphate; sodium hydrogen carbonate, potassium hydrogen carbonate, ammonium hydrogen carbonate; sodium carbonate, potassium carbonate, ammonium carbonate; sodium borate, potassium borate, lithium borate; sodium hydroxide, potassium hydroxide, and ammonium hydroxide.

The alkali developer can contain organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimirne, ethylenediamine, and pyridine.

These alkali agents can be used singly or as a mixture of two or more thereof. The alkali developer can contain an anionic surfactant, an amphoteric surfactant, or an organic solvent such as alcohol.

The alkali developer can be prepared from a developing composition in the form of tablets or granules or a developer concentrate.

The developer concentrate may be prepared by forming a developer solution, followed by evaporation to dryness and is preferably prepared in such a manner that plural components are mixed with a small amount of water or without adding any water. The developer concentrate can also be prepared in the form of granules or tablets, as described in Japanese Patent O.P.I. Publication Nos. 51-61837, 2-109042, 2-109043, 3-39735, 5-142786, 6-266062 and 7-13341. The developer concentrate may be divided into plural parts differing in material species or compounding ratio.

The developer or developer replenisher in the invention can further contain an antiseptic agent, a coloring agent, a viscosity increasing agent, an antifoaming agent, or a water softener.

### (Automatic developing machine)

It is advantageous that an automatic developing machine is used in the development of a light sensitive planographic printing plate material. It is preferred that the automatic developing machine is equipped with a means for automatically introducing a developer replenisher in a necessary amount into a developing bath, a means for discharging any excessive developer and a means for automatically introducing water in necessary amounts to the developing bath. It is preferred that the automatic developing machine comprises a means for detecting a planographic printing plate material to be transported, a means for calculating the area to be processed of the planographic printing plate material based on the detection, or a means for controlling a replenishing amount of a developer replenisher, a replenishing amount of water to be replenished or replenishing timing based on the detection and calculation. It is also preferred that the automatic developing machine comprises a means for controlling a temperature of a developer, a means for detecting a pH andLor electric conductivity of a developer, or a means for controlling a replenishing amount of the developer replenisher, a replenishing amount of water to be replenished andLor the replenishing timing based on the detected pH andLor electric conductivity. It is also preferred that the automatic developing machine have a function of diluting a developer concentrate with water and a function of stirring the diluted concentrate. there developing is followed by washing, water used for washing can be reused as a dilution water for diluting the developer concentrate.

The automatic developing machine used in the invention may be provided with a pre-processing section to allow the plate to be immersed in a pre-processing solution prior to development. The pre-processing section is provided preferably with a mechanism of spraying a pre-processing solution onto the plate surface, preferably with a mechanism of controlling the pre-processing solution at a temperature wLthLn thH UDnJH RI 25 tR 55 °C, DnG SUHIHUDEOy wLth D mechanism of rubbing the plate surface with a roller-type brush. Common water and the like are employed as the pre-processing solution.

### (Post-processing)

The developed printing plate material is preferably subjected to post-processing. The post-processing step comprises post-processing the developed precursor with a post-processing solution such as washing water, a rinsing solution containing a surfactant, a finisher or a protective gumming solution containing gum arabic or starch derivatives as a main component. The post-processing step is carried out employing an appropriate combination of the post-processing solution described above. For example, a method is preferred in which a developed planographic printing plate precursor is post-washed with washing water, and then processed with a rinsing solution containing a surfactant, or a developed planographic printing plate precursor is post-washed with washing water, and then processed with a finisher, since it reduces fatigue of the rinsing solution or the finisher. It is preferred that a multi-step countercurrent processing is carried out employing a rinsing solution or a finisher.

The post-processing is carried out employing an automatic developing machine having a development section and a post-processing section. In the post-processing step, the developed printing plate is sprayed with the post-processing solution from a spray nozzle or is immersed into the post-processing solution in a post-processing tank. A method is known in which supplies a small amount of water onto the developed printing plate precursor to wash the precursor, and reuses the water used for washing as dilution water for developer concentrate. In the automatic developing machine, a method is applied in which each processing solution is replenished with the respective processing replenisher according to the area of the printing plate precursor to have been processed or the operating time of the machine. A method (use-and-discard method) can be applied in which the developed printing plate material is processed with fresh processing solution and discarded. The thus obtained planographic printing plate is mounted on a printing press, and printing is carried out.

### (On-press development)

The light sensitive planographic printing plate material of the invention can be developed on a printing press during a conventional printing without carrying out without carrying out development or post-processing described above.

That is, an imagewise exposed and heated planographic printing plate material is mounted on a printing press, and printing is carried out supplying dampening water and printing ink to the planographic printing plate material and feeding a printing sheet, where the oxygen-shielding layer and the light sensitive layer at non-image portions, i.e., unexposed portions are removed by dampening water and printing ink, and transferred to the printing sheet, whereby the planographic printing plate material is developed.

### EXAMPLES

Next, the present invention will be explained in the following examples, but the present invention is not limited thHUHtR. ,n thH H[DPSOHs, "SDUts" UHSUHsHnts "SDUts Ey wHLJht", XnOHss RthHUwLsH sSHFLILHG.

### «Polymeric Binder: Synthesis of Acryl Copolymer 1»

Seventy parts of methacrylic acid, 30 parts of methyl methacrylate, 500 parts of isopropyl alcohol, and 3 parts of α,α'-D]RELsLsREXtyUR-nLtULOH wHUH SXt Ln D thUHH nHFN IODSN under nitrogen atmosphere, and reacted under nitrogen atmosphere for 6 hours at 80 °C in an oil bath.

After that, the reaction mixture was refluxed at a boiling point of isopropyl alcohol for one hour, and 3 parts of triethylammonium chloride and 25 parts of glycidyl methacrylate were further added to the mixture, and reacted for additional 3 hours to obtain acryl copolymer 1. The weight average molecular weight of the acryl copolymer 1 was 35,000, measured according to GPC. The glass transition tHPSHUDtXUH 7J RI thH DFUyO FRSROyPHU 1 wDs 105 °C, PHDsXUHG according to DSC (differential thermal analysis).

### [Preparation of Support]

A 0.30 mm thick and 1030 mm wide aluminum plate (material JIS A 1050) was successively treated according to the following procedures:
(a) The aluminum plate was subjected to etching treatment, in which the aluminum plate was sprayed with a 70 °C sROXtLRn hDYLnJ D FDXstLF sRGD FRnFHntUDtLRn RI 2.6 weight% and an aluminum ion concentration of 6.5 weight% to dissolve the aluminum by 0.3 gLm², and was washed by means of a water spray.
(b) Desmut treatment was performed by spraying the aluminum plate with an aqueous 1% by weight nitric acid sROXtLRn (FRntDLnLnJ DOXPLnXP LRn RI 0.5 wHLJht%) Dt 30 °C, followed by washing by a water spray.
(c) The resulting aluminum plate was subjected to continuous electrolytic roughening treatment, utilizing an DOtHUnDtLnJ YROtDJH RI 60 H], Ln D 21 °C HOHFtUROytLF solution containing 1.1% by weight hydrochloric acid, 0.5% by weight of an aluminum ion and 0.5% by weight of acetic acid.
   The electrolytic roughening treatment was performed employing a sine wave alternating current at a TP (time taken for current to reach from zero to the peak value) of 2 msec, and employing a carbon electrode as a counter electrode. The current density was 50 ALdm² in terms of effective value, and the quantity of electricity supplied was 900 CLdm². Thereafter, the plate was sprayed with water and washed.
(d) The resulting aluminum plate was desmutted for 10 seconds in an aqueous 20% by weight phosphoric acid solution having an aluminum ion concentration of 0.5% by weight at 60 °C, DnG wDshHG wLth wDtHU sSUDy.
(e) Employing a conventional anodizing treatment apparatus employing a two-step power-supplied electrolysis method (in which a length of each of the first and second electrolysis section is 6 m, the first power supply section is 3 m long, the second power supply section is 3 m long, and a length of each of the first and second power supply electrodes is 2.4 m), anodizing treatment was performed at 38 °C Ln D sROXtLRn hDYLnJ D sXOIXULF DFLG FRnFHntUDtLRn RI 170 gLl (having an aluminum ion concentration of 0.5 weight%) in the electrolysis section. Thereafter, the plate was sprayed with water and washed.

At this time, in the anodizing treatment apparatus, electric current from power source flowed to the first power supply electrode arranged in the first power supply section, then to the aluminum plate through the electrolytic solution to form an oxidized film on the surface of the aluminum plate in the first electrolysis section, and passed through the electrolysis electrode arranged in the first power supply section to return to the power source.

On the other hand, electric current from a power source flowed to the second power supply electrode arranged in the second power supply section, then similarly to the aluminum plate through the electrolytic solution to form an oxidized film on the surface of the aluminum plate in the second electrolysis section. The quantity of electricity supplied from a power source to the first power supply section and the quantity of electricity supplied from a power source to the second power supply section were same, and the power supply electric current density on the oxidized film surface at the second power supply section was approximately 25 ALdm². In the second power supply section, power was supplied from the surface of the oxidized film of 1.35 gLm². The final amount of the oxidized film was 2.7 gLm². The resulting aluminum plate was washed with water, then subjected to hydrophilization treatment in which the plate was immersed in D 85 °C DTXHRXs 0.4% Ey wHLJht SROyYLnyO ShRsShRnLF DFLG solution for 30 seconds, washed with water, and dried with an infrared heater. The aluminum support obtained above had a centerline average surface roughness (Ra) of 0.65 µm.

### (Preparation of Light Sensitive Planographic Printing Plate Material Samples 1 through 3)

The following photopolymerizable light sensitive layer coating solution was coated on the resulting support through D wLUH EDU, DnG GULHG Dt 95 °C IRU 1.5 PLnXtHs tR JLYH D photopolymerizable light sensitive layer having a dry thickness of 1.5 gLm².

After that, the following protective layer coating solution was coated on the photopolymerizable light sensitive ODyHU XsLnJ D wLUH EDU, DnG GULHG Dt 65 °C IRU 3 PLnXtHs tR give a protective layer with a dry thickness of 3.0 gLm². Thus, light sensitive planographic printing plate material samples 1 through 3 with a protective layer on the light sensitive layer were prepared.

### (Photopolymerizable Light Sensitive Layer Coating Solution)

| | |
|---|---|
| Ethylenically unsaturated compound (Nh OLIGO U-4HA, produced by Shinnakamura hagaku Co., Ltd) | 5.0 parts |
| Ethylenically unsaturated compound (Nh ESTER 4G, produced by Shinnakamura hagaku Co., Ltd) | 5.0 parts |
| Ethylenically unsaturated compound (Denacol Acrylate DA314, available from Nagase Chemtex Corporation) | 38.0 parts |
| Spectral Sensitizing Dye (Coumarin 343 having absorption maximum of 443 nm) | Amount as shown in Table 1 |
| η-Cumene-(η-cyclopentadienyl)-iron hexafluorophosphate | 3.0 parts |
| Halogen compound 1 | 3.0 parts |
| Acryl copolymer 1 | 45.0 parts |
| 2-t-Butyl-6-(3-t-butyl-2-hydroxy-5-methylbenzyl)-4-methylphenylacrylate (Sumirizer GS: produced by Sumitomo 3M Co., Ltd.) | 0.5 parts |
| Fluorine-contained surfactant | 0.5 parts |
| (FC-4430: produced by Sumitomo 3M Co., Ltd.) | |
| Propylene glycol monomethyl ether | 900 parts |

Halogen compound 1: CBr₃CONHCH₂C (CH₃)₂CH₂NHCOCBr₃

### Coumarin 343

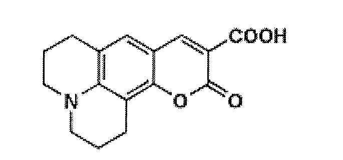

### (Protective layer coating solution)

| | |
|---|---|
| Polyvinyl alcohol (GL-05, produced by Nippon Gosei hagaku Co., Ltd.) | 74 parts |
| Polyvinyl Pyrrolidone (PsP h-30, available from ISP Japan Ltd.) | 10 parts |
| Dye precursor 1 produced by BASF Co., Ltd.) | 5 parts |
| Color-developing agent (Bisphenol A) | 2 parts |
| Polyethylene imine (Lupasol tF, produced by BASF Co., Ltd.) | 5 parts |
| Surfactant (Surfinol 465, produced by Nisshin hagaku hogyo Co., Ltd.) | 0.5 parts |
| tater | 900 parts |

### Dye precursor 1

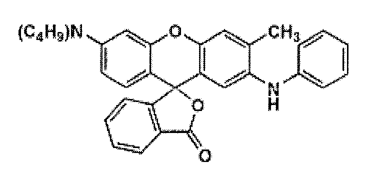

Employing a plate setter (produced by ECRM Co., Ltd.) installed with a light source emitting a 405 nm light, each of the light sensitive planographic printing plate material samples 1 through 3 obtained above was imagewise exposed at a resolving degree of 2400 dpi under red safelight, wherein exposure energy was changed.

Subsequently, the exposed sample was subjected to heat tUHDtPHnt Dt 105 °C IRU 30 sHFRnGs XnGHU UHG sDIHOLJht.

The dye precursor 1 and color-developing agent contained in the protective layer react with each other by heat treatment to form a black dye. It proved that the black dye was a dye absorbing light of all wavelengths including those of from 350 to 450 nm according to the method of measuring absorption spectrum as described previously.

The developed and heated sample being mounted on a printing press DAIYA 1F-1 (produced by Mitsubishi Jukogyo Co., Ltd.), printing was carried out wherein coated paper sheets, printing ink (Toyo hing Hyeco M Magenta, produced by Toyo Ink Manufacturing Co.), and dampening water (H liquid SG 51 having a concentration of 1.5%, produced by Tokyo Ink Co., Ltd.) were employed. In the process in which 50 sheets of prints was obtained after printing started, the protective layer and the image formation layer at non-image portions ware removed from the sample, and transferred to the prints through the blanket of the printing press, whereby so-called on-press development was carried out.

### (Sensitivity)

In the above printing process, exposure energy at which normal ink receptivity was achieved in the fiftieth print was determined and evaluated as a measure of sensitivity. The less the exposure energy is, the higher the sensitivity.

### (Safelight property)

Each sample was imagewise exposed and subjected to heat treatment in the same manner as above, and allowed to stand for various periods (as shown in Table 1) under 500 lux white fluorescent lamp. Thereafter, employing the resulting sample, printing was carried out in the same manner as above, and prints were evaluated in the same manner as above. The period during which no stain was produced in non-image portions was determined and evaluated as a measure of safelight property. The longer the period is, the higher the safelight property. The results are shown in Table 1.

**Table 1**

| Light sensitive planographic printing plate material No. | Spectral Sensitizing Dye (Cumarin 343) Amount | Sensitivity (µ-/Fp²) | Safelight Property (Period) |
|---|---|---|---|
| 1 | 3.0 parts 120 3.0 parts | 120 | Not less than 60 minutes |
| 2 | 1.5 parts 1.5 parts | 200 | Not less than 60 minutes |
| 3 | 1.0 parts | 250 | Not less than 60 minutes |

### Comparative example 1 (Light Sensitive Planographic Printing Plate Material Samples 4 through 6)

Light sensitive planographic printing plate material samples 4 through 6 were prepared in the same manner as in Light sensitive planographic printing plate material samples 1 through 3 above, except that the dye precursor and the color-developing agent were removed from the protective layer coating solution. The resulting sample was evaluated in the same manner as above. The results are shown in Table 2.

**Table 2**

| Light sensitive planographic printing plate material No. | Spectral Sensitizing Dye (Cumarin 343) Amount | Sensitivity (µ-/FP²) | Safelight Property (period) |
|---|---|---|---|
| 4 | 3.0 parts | 120 | G Less than 30 minutes |
| 5 | 1.5 parts | 200 | G Less than 30 minutes |
| 6 | 1.0 parts | 250 | 30 minutes |

| | | | |
|---|---|---|---|
| G Stain was produced in non-image portions at the period of 30 minutes. | | | |

As is apparent from Tables 1 and 2, inventive planographic printing plate material samples provide both high sensitivity and excellent safelight property.

## Claims

1. A light sensitive planographic printing plate material comprising a support and provided thereon, a light sensitive layer and a protective layer (E), the light sensitive layer containing a photopolymerization initiator (A), a polymerizable ethylenically unsaturated compound (B), a dye (C) having absorption maximum in the wavelength regions of from 350 to 450 nm and a polymeric binder (D), and the light sensitive planographic printing plate material being **characterized in that** the protective layer contains a dye precursor (F) capable of changing to a dye absorbing light with a wavelength of from 350 to 450 nm by heating.

2. The light sensitive planographic printing plate material of claim 1, wherein the protective layer (E) further contains a color-developing agent (G).
